# EUROPÄISCHE PATENTSCHRIFT

(11) **EP 1 389 284 B1**
(45) Veröffentlichungstag und Bekanntmachung des Hinweises auf die Patenterteilung: **30.07.2008**
(21) Anmeldenummer: 02716833.5
(22) Anmeldetag: 14.03.2002
(51) Int. Cl.: F16P 3/00, H03K 19/007

(54) **SICHERHEITSSCHALTMODUL ZUR PRÜFUNG DES ABSCHALTVERMÖGENS EINES SCHALTELEMENTS IN EINEM SICHERHEITSSCHALTMODUL**
SAFETY SWITCHING MODULE FOR TESTING THE SWITCHING-OFF ABILITY OF A SWITCHING ELEMENT IN A SAFETY SWITCHING MODULE
MODULE DE COMMUTATION DE SECURITE SERVANT A VERIFIER LA CAPACITE D'INTERRUPTION D'UN ELEMENT DE COMMUTATION DANS UN MODULE DE COMMUTATION DE SECURITE

(30) Priorität: 22.05.2001 DE 10127233
(43) Veröffentlichungstag der Anmeldung: 18.02.2004
(73) Patentinhaber: PILZ GmbH & CO., 73760 Ostfildern (DE)
(72) Erfinder: VEIL, Richard, 70597 Stuttgart (DE); FLEINER, Jürgen, 72768 Reutlingen (DE)
(74) Vertreter: Lindner, Michael
(86) Internationale Anmeldenummer: PCT/EP2002/002840
(87) Internationale Veröffentlichungsnummer: WO 2002/095282

(56) Entgegenhaltungen:
- DE-A- 3 732 079
- DE-A- 10 011 211
- DE-C- 4 224 620
- US-A- 5 381 296

## Beschreibung

Die vorliegende Erfindung betrifft ein Sicherheitsschaltmodul zum sicheren Abschalten einer elektrischen Last, mit einer ersten und einer zweiten Schaltsteuereinrichtung, einem ersten und einem in Reihe dazu angeordneten zweiten Schaltelement, die einen ersten Strompfad zur Versorgung der Last bilden, wobei das erste Schaltelement von der ersten Schaltsteuereinrichtung und das zweite Schaltelement von der zweiten Schaltsteuereinrichtung steuerbar ist, und einer Auswerte- und Steuereinheit zur Prüfung des Abschaltvermögens von zumindest einem Schaltelement.

Solche Sicherheitsschaltmodule bzw. Sicherheitsschaltgeräte sind allgemein bekannt. So bietet die Anmelderin bspw. Sicherheitsschaltgeräte in unterschiedlichen Varianten unter dem Namen "PNOZ" an. In der Patentanmeldung DE 100 11 211 der Anmelderin ist bspw. ein solches Sicherheitsschaltgerät offenbart.

Ferner ist aus DE 37 32 079 C2 ein Verfahren und eine Vorrichtung bekannt, die einen überbrückungsstromkreis für mindestens einen mechanischen Schaltkontakt betreiben.

Allgemein werden derartige Sicherheitsschaltgeräte vor allem im industriellen Bereich verwendet, um elektrisch angetriebene Maschinen, wie bspw. eine Presse oder ein Fräswerkzeug, eine Ventilinsel für Pneumatik- oder Hydrauliksteuerungen oder Ausgangsmodule einer SPS, ein- und sicher auszuschalten. Sie dienen insbesondere in Verbindung mit einem mechanisch betätigbaren Not-Aus-Taster dazu, die Maschine in einer Notfallsituation schnell und sicher abzuschalten. Hierzu wird die Stromversorgung der abzuschaltenden Maschine über zwei in Reihe geschaltete Schaltelemente geführt. Sobald auch nur eines der beiden Schaltelemente öffnet, wird die Stromzuführung der Maschine unterbrochen.

Um im Betrieb eines solchen Sicherheitsschaltgeräts eine Überprüfung des Schaltvermögens der Schaltelemente durchzuführen, ist eine Auswerte- und Steuereinheit vorgesehen, die die Schaltelemente kurzzeitig einzeln abschaltet und dabei das Ausgangssignal (Rücklesesignal) der Schaltelemente erfaßt und auswertet. Anhand dieser Auswertung kann die Auswerte- und Steuereinheit feststellen, ob jedes Schaltelement in der Lage ist, die elektrische Versorgung der Maschine, d.h. allgemein der elektrischen Last in einer Notfallsituation zu unterbrechen. Um die elektrische Last durch diesen Prüfvorgang nicht zu beeinflussen, wird das Schaltelement nur für eine sehr kurze Zeitdauer abgeschaltet, die für die Last nicht "sichtbar" ist.

Aufgrund der Trägheit von elektromechanischen Schaltelementen ist dieser Prüfvorgang nur bei elektronischen Schaltelementen auf der Basis von Halbleiterbauelementen möglich. Übersteigt der von dem Schaltelement zu schaltende Strom jedoch einen bestimmten Wert (typischerweise etwa 8 Ampere) und handelt es sich bei der elektrischen Last nicht um einen reinen Ohmschen Verbraucher (kapazitive oder induktive Bestandteile), so ist der vorgenannte Prüfvorgang durch kurzes Abschalten der Schaltelemente nur mit großem zusätzlichen Bauteilaufwand möglich. Zum Auswerten des Ausgangssignals des Schaltelements müßte nämlich dann zunächst die Last entladen werden, um den Abschaltimpuls klein zu halten. Das kurzzeitige Entladen eines größeren Kondensators würde einen sehr großen Entladestrom erfordern. Um bspw. einen ImF-Kondensator in 200 µs um 25 V zu entladen, ist ein Entladestrom von 125 A erforderlich

Vor diesem Hintergrund besteht die Aufgabe der vorliegenden Erfindung darin, ein Sicherheitsschaltmodul der vorgenannten Art vorzusehen, das auf einfache Weise eine Prüfung des Abschaltvermögens der Schaltelemente auch bei großen zu schaltenden Strömen und/oder kapazitiven oder induktiven Lasten ermöglicht.

Diese Aufgabe wird bei dem Sicherheitsschaltmodul der vorgenannten Art dadurch gelöst, daß ein drittes und ein viertes Schaltelement vorgesehen sind, die in Reihe zueinander und parallel zu der Reihenschaltung aus erstem und zweitem Schaltelement angeordnet sind und einen zweiten Strompfad bilden, wobei das dritte Schaltelement von der ersten Schaltsteuereinrichtung und das vierte Schaltelement von der zweiten Schaltsteuereinrichtung steuerbar ist, und daß die Auswerte- und Steuereinheit die Prüfung beider Schaltelemente in abwechselnd einem der beiden Strompfade durchführt, so daß dann der andere der beiden Strompfade die Last versorgt.

Das heißt mit anderen Worten, daß zusätzlich zu dem bisherigen Strompfad, der durch die beiden Schaltelemente stromlos geschaltet werden kann, ein weiterer Strompfad mit zwei weiteren Schaltelementen parallel geschaltet wird. Im normalen Betrieb wird die Last über, beide Strompfade mit elektrischer Energie versorgt. Während eines Prüfzyklus wird einer der beiden Strompfade auf sein Abschaltvermögen hin geprüft, während dann der andere Strompfad die elektrische Versorgung alleine übernimmt. Somit ist es möglich, weiterhin durch kurzes Abschalten der Schaltelemente eine Prüfung des Abschaltvermögens durch Rücklesen von Ausgangssignalen dieser Schaltelemente durchzuführen, ohne daß dies die Versorgung der elektrischen Last behindern würde. Folglich läßt sich mit einfachen Mitteln ein Sicherheitsschaltmodul zum sicheren Abschalten auch von großen Strömen aufbauen.

Da der Abschaltimpuls an der Last nicht anliegt, sind längere Abschaltimpulse möglich. Das bedeutet, daß mit dem erfindungsgemäßen Aufbau neben Halbleiterbauelementen auch elektromechanische Schaltelemente getestet werden können, während die Last eingeschaltet ist.

Ein weiterer Vorteil des erfindungsgemäßen Aufbaus ist auch darin zu sehen, daß die Versorgungssicherheit erhöht wird, da bei Ausfall eines Strompfads, bspw. aufgrund eines durchlegierten Halbleiter-Schaltelements bei entsprechender Ansteuerung, weiterhin eine sichere Versorgung der Last möglich ist.

In einer vorteilhaften Weiterbildung der Erfindung ist das erste und das dritte Schaltelement als Halbleiter-Schaltelement ausgebildet. Vorzugsweise ist das zweite und das vierte Schaltelement als elektromechanisches Schaltelement, vorzugsweise als Relais ausgebildet.

Diese Maßnahmen haben den Vorteil, daß bspw. die Relaiskontakte den Strom im. Normalbetrieb nicht zu schalten brauchen, da das Halbleiter-Schaltelement schneller schaltet und den Strom bereits abgeschaltet hat. Damit werden die Relaiskontakte geschont und die Lebensdauer wesentlich erhöht. Aufgrund der Verwendung diversitärer Schaltelemente (Halbleiter und Relais) lassen sich Fehler in beiden Schaltelementen durch gleiche Ursachen, bspw. durch einen energiereichen Störimpuls, ausschließen. Selbstverständlich ist es auch denkbar, alle vier Schaltelemente gleich als Halbleiter-Schaltelemente, als wechselstromschaltende Halbleiter-Schaltelemente, vorzugsweise Photo-MOS-Relais, oder als Relais auszubilden

In einer vorteilhaften Weiterbildung ist die Schaltsteuereinrichtung zweikanalig ausgebildet.

Diese Maßnahme hat den Vorteil, daß die Sicherheit des Sicherheitsschaltmoduls weiter erhöht wird.

In einer vorteilhaften Weiterbildung ist die Auswerte- und Steuereinheit mit jedem der beiden Strompfade derart verbunden, daß sie ein Signal zwischen dem ersten und dem zweiten bzw. dem dritten und dem vierten Schaltelement auslesen kann.

Diese Maßnahme hat den Vorteil, daß die Auswerte- und Steuereinheit das Abschaltvermögen beider Schaltelemente in dem jeweiligen Strompfad erfassen kann.

In einer vorteilhaften Weiterbildung ist die Auswerte- und Steuereinheit derart ausgebildet, daß sie einen kurzen Ausschaltimpuls erzeugen und entweder dem ersten oder dem dritten Schaltelement zuführen kann, um dieses kurz auszuschalten. Vorzugsweise wird dieser Ausschaltimpuls dem von der Schaltsteuereinrichtung erzeugten Steuersignal aufmoduliert.

Diese Maßnahmen haben den Vorteil, daß ein sehr einfacher Aufbau zur Prüfung des Abschaltvermögens möglich wird.

Es versteht sich, daß die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden durch die Ansprüche definierten Erfindung zu verlassen.

Ausführungsbeispiele der Erfindung sind in der Zeichnung dargestellt und werden in der nachfolgenden Beschreibung näher erläutert. Es zeigen:
- Fig. 1A: eine schematische Darstellung eines Sicherheitsschaltgeräts gemäß einer ersten Ausführungsform;
- Fig. 1B: eine schematische Darstellung eines Sicherheitsschaltgeräts gemäß einer zweiten Ausführungsform;
- Fig. 2: ein schematisches Schaltungsdiagramm des erfindungsgemäßen Sicherheitsschaltmoduls in einer einpoligen Ausführung; und
- Fig. 3: ein schematisches Schaltungsdiagramm des erfindungsgemäßen Sicherheitsschaltmoduls in einer zweipoligen Ausführung.

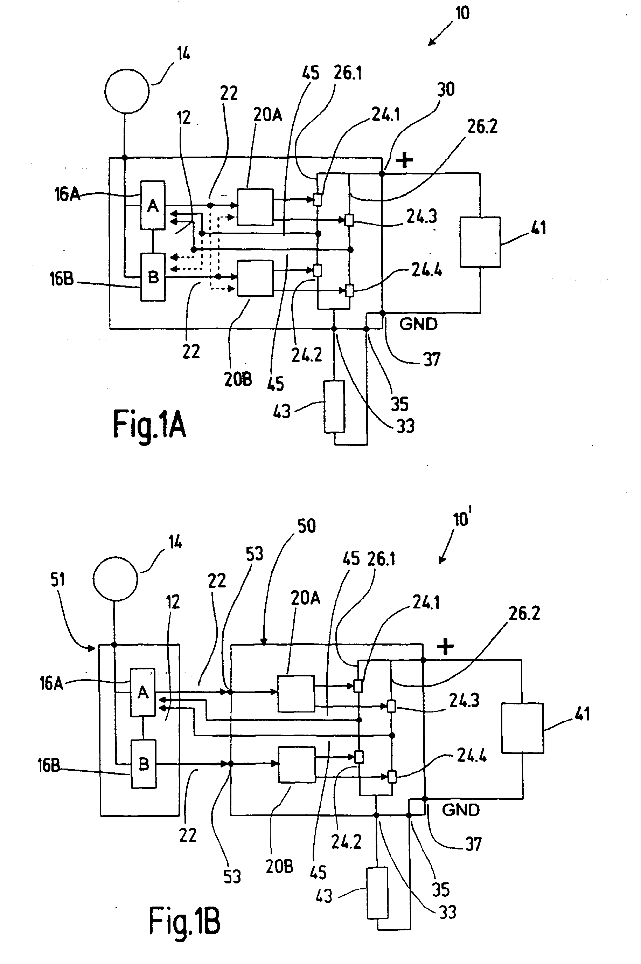

In Fig. 1A ist in schematischer Darstellung ein Sicherheitsschaltgerät gezeigt und mit dem Bezugszeichen 10 gekennzeichnet. Das Sicherheitsschaltgerät 10 umfaßt eine schematisch angedeutete sichere Auswert- und Steuereinheit 12. Diese Auswert- und Steuereinheit 12 ist aus bekannten Bauelementen aufgebaut, wie sie auch in dem vorgenannten Sicherheitsschaltgerät "PNOZ" der Anmelderin verwendet werden. Die Aufgabe dieser Auswerte- und Steuereinheit besteht darin, zugeführte Schaltsignale, bspw. von einem Not-Aus-Schalter 14, sicher auszuwerten und entsprechende Ausgangssignale zu erzeugen.

Die Auswerte- und Steuereinheit 12 ist im gezeigten Ausführungsbeispiel zweikanalig aufgebaut, wobei die beiden Kanäle mit dem Bezugszeichen 16a und 16b gekennzeichnet sind. Selbstverständlich sind auch andere Ausgestaltungen der Auswerte- und Steuereinheit 12 möglich. Zur näheren Erläuterung einer solchen Auswerte- und Steuereinheit 12 wird bspw. auf das Buch "Maschinensicherheit", Winfried Gräf, Hüthig-Verlag, 1997, Bezug genommen.

Das Sicherheitsschaltgerät 10 umfaßt ferner pro Kanal eine Ansteuereinrichtung (Schaltsteuereinrichtung) 20A bzw. 20B, die jeweils ein Steuersignal von der entsprechenden Auswerte- und Steuereinheit 16a bzw. 16b über Leitungen 22 empfangen. Obgleich in Fig. 1A für die Leitungen 22 jeweils nur eine Linie dargestellt ist, kann es sich bei den Leitungen 22 auch um mehradrige Busleitungen handeln.

Die Ansteuereinrichtung 20 erzeugt abhängig von den zugeführten Steuersignalen von der Auswerte- und Steuereinheit 12 Ansteuersignale, die Schaltelementen 24.1 bis 24.4 zugeführt werden. Die Fig. 1A läßt erkennen, daß die Ansteuereinrichtung 20A zwei Ansteuersignale erzeugt, die den beiden Schaltelementen 24.1 und 24.3 zugeführt werden. Die Ansteuereinrichtung 20B erzeugt ebenfalls zwei Ansteuersignale, die jedoch den beiden Schaltelementen 24.2 und 24.4 zugeführt werden. Die beiden von der Ansteuereinrichtung 20A bzw. 20B erzeugten Ansteuersignale sind jeweils gleich, so daß im normalen Betrieb des Sicherheitsschaltgeräts 10 die Schaltelementpaare 24.1 und 24.3 bzw. 24.2 und 24.4 den gleichen Schaltzustand haben.

Erfindungsgemäß sind die insgesamt vier Schaltelemente 24.1 bis 24.4 so angeordnet, daß zwei identische Strompfade 26.1 und 26.2 gebildet werden. Insbesondere sind die beiden Schaltelemente 24.1 und 24.2 in Reihe geschaltet, so daß sie den ersten Strompfad 26.1 bilden, während die anderen beiden Schaltelemente 24.3 und 24.4 ebenfalls in Reihe geschaltet sind und den zweiten Strompfad 26.2 bilden. Aus der Darstellung in Fig. 1A ergibt sich deutlich, daß die beiden Strompfade 26.1, 26.2 parallel zueinander liegen. Die beiden Strompfade 26.1, 26.2 verbinden einen Eingangsanschluß 30 des Sicherheitsschaltgeräts 10 mit einem Ausgangsanschluß 33. Bei eingeschalteten Schaltelementen 24 wird somit eine ohmsche Verbindung zwischen dem Eingangsanschluß 30 und dem Ausgangsanschluß 33 geschaffen, wobei ein entsprechender Strom über beide Strompfade 26 fließen kann.

Neben dem Ausgangsanschluß 33 weist das Sicherheitsschaltgerät 10 einen weiteren Ausgangsanschluß 35 und einen weiteren Eingangsanschluß 37 auf. Aus der Fig. 1A ist ersichtlich, daß zwischen dem Eingangsanschluß 37 und dem Ausgangsanschluß 35 eine elektrische Verbindung besteht.

Im Betrieb wird an die beiden Eingangsanschlüsse 30, 37 eine Gleichspannungsquelle 41 angeschlossen, die bspw. eine Spannung von 24 Volt zwischen den beiden Anschlüssen 30, 37 bereitstellt, wobei der Eingangsanschluß 30 auf einem positiven Potential und der Eingangsanschluß 37 auf einem Bezugspotential, bspw. 0 Volt liegt.

Die von dem Sicherheitsschaltgerät 10 zu schaltende Last ist in Fig. 1A schematisch dargestellt und mit dem Bezugszeichen 43 gekennzeichnet. Im vorliegenden Ausführungsbeispiel handelt es sich um eine Last hoher Leistung, bspw. Ventilinseln für Pneumatik- oder Hydrauliksteuerungen, oder Ausgangsmodule einer SPS-Steuerung, die einen Strom > 8 Ampere benötigt. Die Last 43 ist zwischen den Ausgangsanschlüssen 33 und 35 angeschlossen. Daraus ergibt sich, daß sich bei eingeschalteten Schaltelementen 24 ein Stromfluß von der Gleichspannungsquelle 41 über den Eingangsanschluß 30, die beiden Strompfade 26.1, 26.2, den Ausgangsanschluß 33, die Last 43, den Ausgangsanschluß 35, und den Eingangsanschluß 37 zurück zur Gleichspannungsquelle 41 ergibt. Wird nun bspw. der Not-Aus-Schalter 14 betätigt, erzeugt die Auswerte- und Steuereinheit 12 Steuersignale, die von den beiden Ansteuereinrichtungen 20A, 20B in entsprechende Ansteuersignale umgewandelt werden. Diese Ansteuersignale verursachen ein Ausschalten der Schaltelemente 24, um die beiden Strompfade 26.1, 26.2 stromlos zu schalten. Damit wird die Last 43 von der Gleichspannungsquelle 41 getrennt.

Bei derartigen Sicherheitsschaltgeräten 10 ist es erforderlich, das Abschaltvermögen der Schaltelemente 24 in regelmäßigen Abständen zu testen. Hierfür wird zwischen den beiden Schaltelementen 24.1 und 24.2 des ersten Strompfads 26.1 sowie zwischen den beiden Schaltelementen 24.3 und 24.4 des zweiten Strompfads 26.2 ein Signal abgegriffen und der Auswerte- und Steuereinheit 12 zugeführt. Dies ist in Fig. 1A durch die beiden mit dem Bezugszeichen 45 gekennzeichneten Pfeile angedeutet.

Das Abschaltvermögen der Schaltelemente wird nun dadurch getestet, daß die beiden Schaltelemente in einem Strompfad für eine kurze Zeitdauer abgeschaltet werden, während die Schaltelemente in dem anderen Strompfad ihren Schaltzustand beibehalten. Das kurze Abschalten der Schaltelemente in einem Strompfad führt dazu, daß sich das Potential zwischen den beiden getesteten Schaltelementen verändert, sofern die Schaltelemente in Ordnung sind. Diese Potentialveränderung kann die Auswerte- und Steuereinheit 12 erkennen und entsprechend auswerten. Sollte sich bspw. das Schaltelement 24.1 im ersten Strompfad 26.1 nicht mehr öffnen lassen, so verändert sich das Potential während der kurzen Testphase nicht, was von der Auswerte- und Steuereinheit 12 als Fehler erkannt wird. Eine sofortige Abschaltung des gesamten Sicherheitsschaltgeräts und damit auch der Last 43 wäre die Folge.

Dadurch, daß zwei Strompfade 26.1, 26.2 vorgesehen sind, von denen jeweils nur einer einem Test unterzogen wird, wird eine gleichbleibende Energieversorgung der Last 43 auch während der Testphase garantiert. Somit ist es mit diesem Sicherheitsschaltgerät 10 möglich, das Abschaltvermögen von Schaltelementen zu testen, obgleich sehr große Ströme fließen. Darüber hinaus spielt es keine Rolle, ob die Last 43 eine rein ohmsche Last oder bspw. eine kapazitive Last ist.

Fig. 1A läßt noch gestrichelt dargestellte Verbindungen erkennen, die von den beiden Auswerte- und Steuereinheiten 16A,B zu den Ansteuereinrichtungen 20A,B verlaufen und von den Rückleseleitungen zu den Auswerte- und Steuereinheiten 16A,B. Diese Verbindungen dienen dazu, die zweikanalige Struktur des Sicherheitsschaltgeräts fortzusetzen; diese Verbindungen ermöglichen es jeder Auswerte- und Steuereinheit 16A,B, alle vier Schaltelemente 24.1-24.4 anzusteuern und zu überprüfen.

In Fig. 1B ist ein Sicherheitsschaltgerät 10' gezeigt, das hinsichtlich der Funktion dem bereits mit Bezug auf die Fig. 1A gezeigten Sicherheitsschaltgerät 10 entspricht. Auf eine nochmalige ausführliche Beschreibung soll deshalb an dieser Stelle verzichtet werden. Auch der konstruktive Aufbau des Sicherheitsschaltgeräts 10' unterscheidet sich nicht von dem des Sicherheitsschaltgeräts 10. Der einzige Unterschied besteht darin, daß das Sicherheitsschaltgerät 10' in zwei Module 50, 51 aufgeteilt wurde. Das Modul 50, das nachfolgend als Sicherheitsschaltmodul bezeichnet wird, umfaßt die Ansteuereinrichtungen 20A, 20B sowie die Schaltelemente 24, die in den beiden Strompfaden 26.1, 26.2 angeordnet sind. Das Modul 51, das nachfolgend als Auswerte- und Steuermodul bezeichnet wird, umfaßt die Auswerte- und Steuereinheit 12, deren Steuersignale Eingangsanschlüssen 53 des Sicherheitsschaltmoduls 50 zuführbar sind. Durch die Aufgliederung des Sicherheitsschaltgeräts 10' in zwei einzelne Module 50, 51 läßt sich die Flexibilität steigern. Insbesondere kann das Sicherheitsschaltmodul 50 als Zusatzmodul zum Schalten großer Ströme an bereits existierende Sicherheitsschaltgeräte angeschlossen werden.

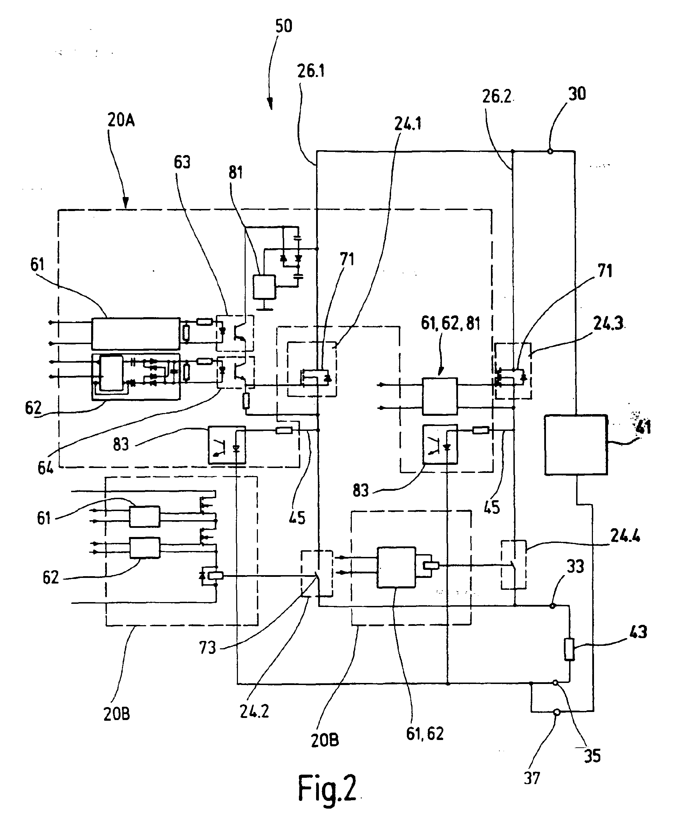

Mit Bezug auf die Fig. 2 soll nun nachfolgend eine konkrete bevorzugte Ausgestaltung des Sicherheitsschaltmoduls 50 gezeigt werden, wobei an dieser Stelle jedoch anzumerken ist, daß es sich hierbei um eine rein beispielhafte Schaltungsanordnung handelt. Zur Erzielung der mit Bezug auf die Fig. 1A beschriebenen Funktionsweise sind selbstverständlich auch andere Schaltungsanordnungen denkbar.

Zur Vereinfachung sind in Fig. 2 für die gleichen Bauelemente gleiche Bezugszeichen angegeben, so daß auf eine nochmalige Beschreibung dieser Bauelemente verzichtet werden kann.

Mit gestrichelten Linien sind die einzelnen Funktionsblöcke, nämlich die beiden Ansteuereinrichtungen 20A, 20B sowie die Schaltelemente 24.1 bis 24.4 dargestellt.

Die Ansteuereinrichtung 20A umfaßt im vorliegenden Ausführungsbeispiel zwei Ansteuereinheiten 61, 62, die abhängig von entsprechenden Eingangssignalen jeweils ein Ausgangssignal erzeugen, das jeweils einem Optokoppler 63 bzw. 64 zugeführt wird. Die Ausgänge der beiden Optokoppler 63, 64 sind in Reihe geschaltet und dienen dazu, das Schaltelement 24.1 anzusteuern. Hierzu wird der Steuereingang des Schaltelements 24.1 über die Ausgänge der Optokoppler 63, 64 an ein positives Potential gelegt. Liegen entsprechende Steuersignale an den Eingängen der beiden Optokoppler 63, 64 an, werden die Ausgänge der beiden Optokoppler miteinander verbunden, so daß dann das Schaltelement 24.1 ein Ansteuersignal mit positivem Potential empfängt und aufgrund dessen schließt. Dies ist der normale Betriebsmodus des Sicherheitsschaltmoduls 50, um die Last 43 mit Energie zu versorgen.

Im vorliegenden Ausführungsbeispiel ist das Schaltelement 24.1 als Halbleiter-Schaltelement, vorzugsweise als Feldeffekttransistor 71 ausgebildet.

Im Gegensatz dazu ist das zweite Schaltelement 24.2 im gleichen Strompfad 26.1 als elektromechanisches Schaltelement, vorzugsweise als Relais 73 ausgebildet. Dieses Relais 73 wird über entsprechende Ansteuereinheiten 61, 62 gesteuert. Da das Relais 73 selbst eine galvanische Trennung zu der Ansteuereinrichtung 20B schafft, kann auf den Einsatz von Optokopplern 63, 64 verzichtet werden.

In beiden Fällen ist jedoch anzumerken, daß die Ansteuerung des Feldeffekttransistors 71 bzw. des Relais 73 zweikanalig erfolgt. Nur wenn beide Ansteuereinheiten 61, 62 ein entsprechendes Ansteuersignal erzeugen, wird das Schaltelement 24.1, 24.2 geschlossen.

Die Auswerte- und Steuereinheit 12 prüft das Abschaltvermögen der Schaltelemente 24 durch kurzzeitiges Abschalten der Schaltelemente eines Strompfades

Zur Prüfung des Abschaltvermögens des FET 71 und des Kontakts 73 wird über die Leitung 45 ein Signal zwischen den beiden Schaltelementen 24.1, 24.2 abgegriffen und einem Optokoppler 83 zugeführt. Dieser Optokoppler 83 erzeugt ein Rücklesesignal, das der Auswerte- und Steuereinheit 12 zugeführt wird. Dieses Rücklesesignal gibt Aufschluß darüber, ob während der Testphase der FET 71 und der Kontakt 73 abschaltet. Tun dies beide Schaltelemente 71 und 73, ist die Sicherheit gewährleistet; tun sie dies jedoch nicht, ist der FET 71 oder der Kontakt 73 fehlerhaft mit der Folge, daß das gesamte Sicherheitsschaltmodul 50 abgeschaltet werden muß, so daß die Last 43 in den sicheren Zustand gebracht wird.

Der Aufbau des zweiten Strompfads 26.2 entspricht exakt demjenigen des Strompfads 26.1, so daß auf eine nochmalige Beschreibung an dieser Stelle verzichtet werden kann. Der Übersichtlichkeit wegen sind einige Elemente zu einem Funktionsblock zusammengefaßt worden, bspw. die beiden Ansteuereinheiten 61, 62 und der Taktgenerator 81. Auch im zweiten Strompfad 26.2 wird das Abschaltvermögen des FET 71 und des Kontakts 24.4 durch Aufmodulieren eines kurzen Abschaltimpulses auf das Ansteuersignal durchgeführt. Über einen Optokoppler 83 wird dann ein entsprechendes Rücklesesignal erzeugt.

Wesentlich an der Durchführung der Tests der Schaltelemente ist, daß immer nur ein Strompfad getestet wird, so daß der jeweils andere Strompfad eine entsprechende ununterbrochene Energieversorgung der Last 43 auch während der Testphase garantieren kann.

In dem in Fig. 2 gezeigten Ausführungsbeispiel sind die Schaltelemente eines Strompfads diversitär ausgebildet. Damit sind Fehler in einem Strompfad aufgrund gleicher Ursachen ausschließbar. Selbstverständlich können neben dieser bevorzugten Ausführungsform in einem Strompfad auch gleiche Schaltelemente, insbesondere Halbleiter-Schaltelemente oder elektromechanische Schaltelemente eingesetzt werden.

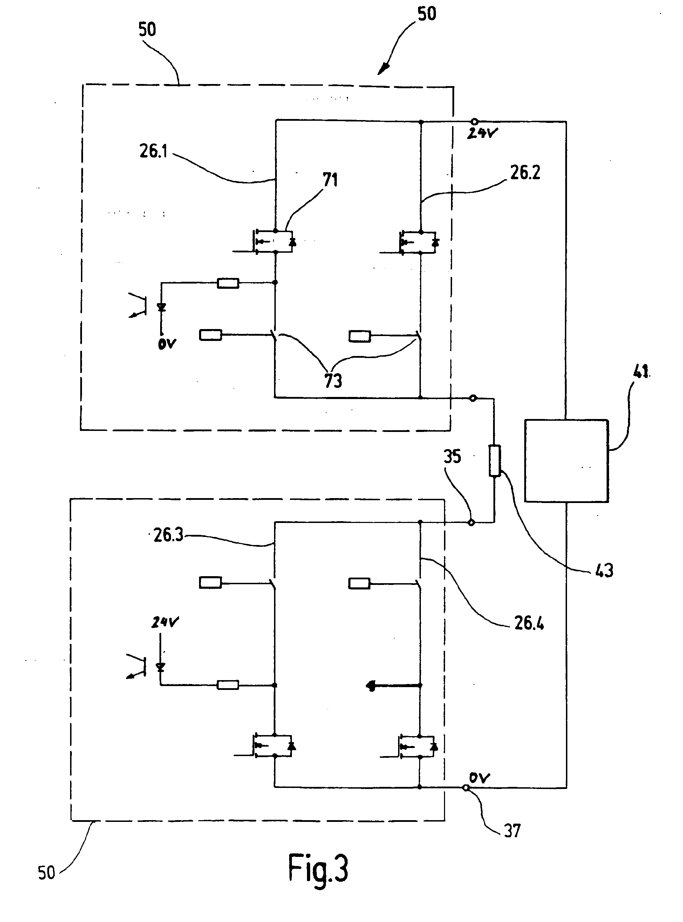

Ein weiteres Ausführungsbeispiel eines Sicherheitsschaltmoduls ist in Fig. 3 gezeigt und mit dem Bezugszeichen 50' gekennzeichnet. Der Unterschied zu dem in Fig. 2 gezeigten Sicherheitsschaltmodul 50 besteht darin, daß es sich um eine zweipolige Ausführung eines Sicherheitsschaltmoduls handelt. D.h., daß die Last 43 zwischen zwei Sicherheitsschaltmodulen 50, wie in Fig. 2 dargestellt, liegt. Die Verbindung zwischen dem Anschluß 35 und dem Anschluß 37 erfolgt somit nicht direkt, sondern ebenfalls über zwei Strompfade 26.3 und 26.4, die in vertauschter Anordnung zu den beiden Strompfaden 26.1 und 26.2 aufgebaut sind. Die Funktionsweise entspricht jedoch dem Sicherheitsschaltmodul 50, wie es in Fig. 2 gezeigt und beschrieben wurde, so daß auf eine nochmalige Beschreibung verzichtet werden kann.

Der Vorteil ist, daß die Last auch bei einem 24V-Kurzschluß noch sicher abgeschaltet werden kann.

Zusammenfassend ist also festzustellen, daß das erfindungsgemäße Vorsehen zweier Strompfade, die abwechselnd getestet werden, auch ein Schalten hoher Ströme zuläßt, ohne auf eine Prüfung des Abschaltvermögens der Schaltelemente verzichten zu müssen oder hierfür komplizierte Prüfschaltungen schaffen zu müssen, die eventuell auf die jeweilige Last angepaßt werden müssen.

Durch die erfindungsgemäße Schaltungsanordnung sind Unterbrechungen der Schaltelemente möglich, die länger dauern als die Abschaltreaktionszeit der Last. Damit ist auch der Test von Relais während des Betriebs möglich.

## Patentansprüche

1. Sicherheitsschaltmodul zum sicheren Abschalten einer elektrischen Last (43), mit einer ersten und einer zweiten Schaltsteuereinrichtung (20A, 20B), einem ersten und einem in Reihe dazu angeordneten zweiten Schaltelement (24.1, 24.2), die einen ersten Strompfad (26.1) zur Versorgung der Last bilden, wobei das erste Schaltelement (24.1) von der ersten Schaltsteuereinrichtung (20A) und das zweite Schaltelement (24.2) von der zweiten Schaltsteuereinrichtung (20B) steuerbar ist, und mit einer Auswerte- und Steuereinrichtung (12) zur Prüfung des Abschaltvermögens von zumindest einem Schaltelement, **dadurch gekennzeichnet, daß** ein drittes und ein viertes Schaltelement (24.3, 24.4) vorgesehen sind, die in Reihe zueinander und parallel zu der Reihenschaltung aus erstem und zweitem Schaltelement (24.1, 24.2) angeordnet sind und einen zweiten Strompfad (26.2) bilden, wobei das dritte Schaltelement (24.3) von der ersten Schaltsteuereinrichtung (20A) und das vierte Schaltelement (24.4) von der zweiten Schaltsteuereinrichtung (20B) steuerbar ist, und daß die Auswerte- und Steuereinrichtung (12) die Prüfung der Schaltelemente (24) in abwechselnd einem der beiden Strompfade (26.1, 26.2) durchführt, so daß der andere der beiden Strompfade (26.2, 26.1) die Last (43) versorgt.

2. Sicherheitsschaltmodul nach Anspruch 1, **dadurch gekennzeichnet, daß** das erste und das dritte Schaltelement (24.1, 24.3) als Halbleiter-Schaltelemente (71) ausgebildet sind.

3. Sicherheitsschaltmodul nach Anspruch 1 oder 2, **dadurch gekennzeichnet, daß** das zweite und das vierte Schaltelement (24.2, 24.4) als elektromechanisches Schaltelement (73), vorzugsweise als Relais ausgebildet sind.

4. Sicherheitsschaltmodul nach einem der vorhergehenden Ansprüche, **dadurch gekennzeichnet, daß** die Schaltsteuereinrichtungen (20A, 20B, 61, 62) zweikanalig ausgebildet sind.

5. Sicherheitsschaltmodul nach einem der vorhergehenden Ansprüche, **dadurch gekennzeichnet, daß** die Strompfade auf einer Seite mit einer Versorgungsspannung und auf der anderen Seite mit der Last verbunden sind.

6. Sicherheitsschaltmodul nach einem der vorhergehenden Ansprüche, **dadurch gekennzeichnet, daß** die Auswerte- und Steuereinrichtung (12, 83) mit jedem der beiden Strompfade (26.1, 26.2) zwischen dem ersten und dem zweiten (24.1, 24.2) bzw. dem dritten und dem vierten Schaltelement (24.3, 24.4) verbunden ist.

7. Sicherheitsmodul nach einem der vorhergehenden Ansprüche, **dadurch gekennzeichnet, daß** die Auswerte- und Steuereinrichtung einen kurzen Ausschaltimpuls erzeugt und entweder dem ersten und dem zweiten Schaltelement (24.1, 24.2) oder dem dritten und vierten Schaltelement (24.3, 24.4) zuführt, um diese kurz auszuschalten.

8. Sicherheitsmodul nach Anspruch 6, **dadurch gekennzeichnet, daß** der Ausschaltimpuls dem Signal der Schaltsteuereinrichtung aufmoduliert wird.

9. Sicherheitsmodul nach einem der vorhergehenden Ansprüche, **dadurch gekennzeichnet, daß** die Schaltelemente (24.1 - 24.4) elektromechanische Schaltelemente, vorzugsweise Relais, sind.

10. Sicherheitsmodul nach einem der Ansprüche 1 bis 7, **dadurch gekennzeichnet, daß** die Schaltelemente (24.1 - 24.4) Halbleiter-Schaltelemente sind.

## Claims

1. Safety switching module for safely switching-off an electrical load (43), comprising
a first and a second switching control device (20A, 20B);
a first and a second switching element (24.1, 24.2) both being series-connected with each other and forming a first current path (26.1) for supplying the load, whereby the first switching element (24.1) can be controlled by the first switching control device (20A) and the second switching element (24.2) can be controlled by the second switching control device (20B); and
an evaluation and control device (12) for testing the switching-off ability of at least one switching element,
**characterized in that**
a third and a fourth switching element (24.3, 24.4) are provided which are connected to each other in series, are connected in parallel to the series connection consisting of said first and second switching elements (24.1, 24.2) and form a second current path (26.2), the third switching element (24.3) being controlled by the first switching control device (20A) and the fourth switching element (24.4) being controlled by the second switching control device (20B); and
said evaluation and control device (12) carries out the test of the switching elements (24) alternating in one of both current paths (26.1, 26.2) so that the other of both current paths (26.2, 26.1) supplies the load (43).

2. The safety switching module of claim 1, **characterized in that** said first and said third switching element (24.1, 24.3) are provided as semiconductor switching elements (71).

3. The safety switching module of claim 1 or 2, **characterized in that** said second and said fourth switching element (24.2, 24.4) are provided as electromechanical switching elements (73).

4. The safety switching module of any of the preceding claims, **characterized in that** said switching control devices (20A, 20B, 61, 62) are provided as a dual-channel switching control device.

5. The safety switching module of any of the preceding claims, **characterized in that** said current paths are coupled with a supply voltage on one side and with the load on the other side.

6. The safety switching module of any of the preceding claims, **characterized in that** the evaluation and control device (12, 83) is coupled with each of both current paths (26.1, 26.2) between said first and second switching elements (24.1, 24.2) and said third and fourth switching elements (24.3, 24.4), respectively.

7. The safety switching module of any of the preceding claims, **characterized in that** said evaluation and control device generates a short switching-off pulse and supplies the pulse either said first and second switching elements (24.1, 24.2) or said third and fourth switching elements (24.3, 24.4) in order to switch them off shortly.

8. The safety switching module of claim 6, **characterized in that** said switching-off pulse is modulated on said signal of the switching control device.

9. The safety switching module of any of the preceding claims, **characterized in that** said switching elements (24.1-24.4) are provided as electromechanical switching elements, preferably relays.

10. The safety switching module of any of claims 1 to 7, **characterized in that** said switching elements (24.1-24.4) are provided as semiconductor switching elements.

## Revendications

1. Module de commutation de sécurité destiné à interrompre avec fiabilité une charge électrique (43), comprenant un premier et un second dispositifs de commande de sécurité (20A, 20B), un premier élément de commutation et un deuxième élément de commutation (24.1, 24.2) disposé en série par rapport à celui-ci, qui forment un premier trajet de courant (26.1) destiné à alimenter la charge, le premier élément de commutation (24.1) pouvant être commandé par le premier dispositif de commande de commutation (20A) et le deuxième élément de commutation (24.2) pouvant être commandé par le second dispositif de commande de commutation (20B), et comprenant un dispositif d'analyse et de commande (12) destiné à surveiller la capacité d'interruption d'au moins un élément de commutation, **caractérisé en ce qu'**un troisième et un quatrième éléments de commutation (24.3, 24.4) sont prévus, qui sont disposés en série les uns par rapport aux autres et parallèlement au branchement en série des premier et deuxième éléments de commutation (24.1, 24.2) et forment un second trajet de courant (26.2), le troisième élément de commutation (24.3) pouvant être commandé par le premier dispositif de commande de commutation (20A) et le quatrième élément de commutation (24.4) pouvant être commandé par le second dispositif de commande de commutation (20B), et **en ce que** le dispositif d'analyse et de commande (12) réalise la surveillance des éléments de commutation (24) tout à tour dans un des deux trajets de courant (26.1, 26.2), de sorte que l'autre des deux trajets de courant (26.2, 26.1) amène la charge (43).

2. Module de commutation de sécurité selon la revendication 1, **caractérisé en ce que** le premier et le troisième éléments de commutation (24.1, 24.3) sont conçus comme des éléments de commutation à semi-conducteur (71).

3. Module de commutation de sécurité selon la revendication 1 ou 2, **caractérisé en ce que** le deuxième et le quatrième éléments de commutation (24.2, 24.4) sont conçus comme un élément de commutation électromécanique (73), de préférence comme un relais.

4. Module de commutation de sécurité selon l'une quelconque des revendications précédentes, **caractérisé en ce que** les dispositifs de commande de commutation (20A, 20B, 61, 62) sont conçus avec deux canaux.

5. Module de commutation de sécurité selon l'une quelconque des revendications précédentes, **caractérisé en ce que** les trajets de courant sont reliés sur un côté à une tension d'alimentation et sur l'autre côté à la charge.

6. Module de commutation de sécurité selon l'une quelconque des revendications précédentes, **caractérisé en ce que** le dispositif d'analyse et de commande (12, 83) est relié à chacun des deux trajets de courant (26.1, 26.2) entre le premier et le deuxième (24.1, 24.2) et/ou le troisième et le quatrième éléments de commutation (24.3, 24.4).

7. Module de commutation de sécurité selon l'une quelconque des revendications précédentes, **caractérisé en ce que** le dispositif d'analyse et de commande produit une courte impulsion d'interruption et l'amène soit au premier et au deuxième éléments de commutation (24.1, 24.2) soit au troisième et au quatrième éléments de commutation (24.3, 24.4), afin de les interrompre brièvement.

8. Module de commutation de sécurité selon la revendication 6, **caractérisé en ce que** l'impulsion d'interruption est modulée sur le signal du dispositif de commande de commutation.

9. Module de commutation de sécurité selon l'une quelconque des revendications précédentes, **caractérisé en ce que** les éléments de commutation (24.1-24.4) sont des éléments de commutation électromécaniques, de préférence des relais.

10. Module de commutation de sécurité selon l'une quelconque des revendications 1 à 7, **caractérisé en ce que** les éléments de commutation (24.1-24.4) sont des éléments de commutation à semi-conducteur.
